# EUROPÄISCHE PATENTSCHRIFT

(11) **EP 0 690 494 B1**
(45) Veröffentlichungstag und Bekanntmachung des Hinweises auf die Patenterteilung: **17.03.2004**
(21) Anmeldenummer: 95109271.7
(22) Anmeldetag: 14.06.1995
(51) Int. Cl.: H01L 21/768, H01L 23/52, H05K 3/46

(54) **Verbindungs- und Aufbautechnik für Multichip-Module**
Connection and build-up-process for multi-chip-modules
Technologie pour connecter et construire des modules multi-chip

(30) Priorität: 27.06.1994 DE 4422345
(43) Veröffentlichungstag der Anmeldung: 03.01.1996
(73) Patentinhaber: Infineon Technologies AG, 81669 München (DE)
(72) Erfinder: Leuschner, Rainer, Dr., D-91056 Erlangen (DE); Ahne, Hellmut, Dr., D-91341 Röttenbach (DE); Birkle, Siegfried, Dr., D-91315 Höchstadt/Aisch (DE); Hammerschmidt, Albert, Dr., D-91056 Erlangen (DE); Sezi, Recai, Dr., D-91341 Röttenbach (DE); Noll, Tobias, Prof. Dr., D-52072 Aachen (DE); Dumoulin, Ann, Dr., B-8210 Zedelgem (BE)
(74) Vertreter: Müller - Hoffmann & Partner

(56) Entgegenhaltungen:
- EP-A- 0 190 490
- EP-A- 0 290 222
- EP-A- 0 290 271
- EP-A- 0 442 718
- EP-A- 0 489 411
- WO-A-88/05252
- DD-A- 272 755
- US-A- 5 108 785

## Beschreibung

Die Erfindung betrifft ein Verfahren zur Herstellung von Multichip-Modulen mit Schichtfolgen aus dielektrischem Material mit darin eingebetteten Leiterbahnen.

Wegen der fortschreitenden Miniaturisierung von Logikschaltungen in Siliciumschips sind heutzutage die Grenzen der konventionellen Leiterplattentechnik erreicht, um die Verdrahtung zwischen verschiedenen Chips aufzubauen. Dies ist hauptsächlich darauf zurückzuführen, daß - aufgrund der Rent'schen Regel - die Anzahl der Anschlüsse pro Chip (Bondpads) mit zunehmender Gatteranzahl wächst ("GEC Journal of Research", Vol. 7 (1989), No. 1, Seiten 16 bis 27). Infolgedessen müssen dann die Leiterbahnen auf der Leiterplatte schmaler werden, weil sonst nicht genügend Leiterbahnen an den Chip herangeführt werden können. Mit der Anzahl der Leiterbahnen wächst aber auch die Anzahl der Leiterbahnebenen, was die Fertigungstechnologie vor schwierige Aufgaben stellt. Mit der Anzahl der Ebenen nimmt nämlich sowohl die Topographie als auch die Durchbiegung des Substrats zu, was die lithographische Abbildungsgüte verschlechtert.

Als Ausweg werden die sogenannten Multichip-Module (MCMs) angesehen. Dies sind Baugruppen, die jeweils aus mehreren ungehäusten Chips bestehen, welche gemeinsam - mit hoher Verdrahtungsdichte - auf einem Substrat angeordnet sind. Bei den Multichip-Modulen wird von der konventionellen Leiterplattentechnik weggegangen und es werden Verfahren der Siliciumtechnologie für die Verbindungs- und Aufbautechnik genutzt. Auf diese Weise konnte auch die Breite der Leiterbahnen von ca. 100 µm auf einige µm gesenkt werden ("Journal of the Electrochemical Society", Vol. 137 (1990), Seiten 961 bis 966).

Bei Verbindungs- und Aufbautechniken für MCMs müssen eine Reihe von Punkten berücksichtigt werden, insbesondere hinsichtlich der Materialeigenschaften und der Strukturierbarkeit der eingesetzten Dielektrika sowie der Topographie bzw. der Planarisierung. Dazu zählt auch das Aspektverhältnis der Leiterbahnen, das das Verhältnis von Höhe zu Breite angibt. Bei allen bislang bekannten MCM-Aufbauten beträgt das Aspektverhältnis < 1, d.h. die Leiterbahnen sind flach liegend angeordnet.

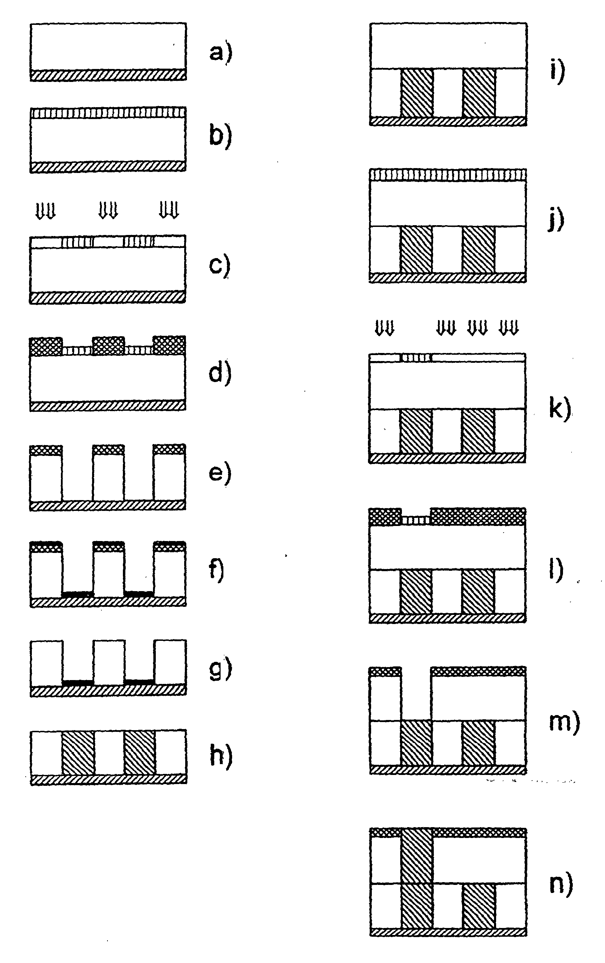

Zum Aufbau von MCMs ist es bereits bekannt, ein Dielektrikum auf der Basis von Benzocyclobuten (BCB) einzusetzen ("National Electronic Packaging and Production Conference", Boston, 11. bis 14. Juni 1990, Tagungsbericht Seiten 667 bis 672). Die Vorteile dieses Materials liegen in einer niedrigen Dielektrizitätskonstante (DK < 3) und in dem - im Vergleich zu herkömmlichen Polyimiden - sehr geringen Schrumpf beim Trocknen ("curing"). Die niedrige Dielektrizitätskonstante ermöglicht dünnere Schichten, einen kürzeren Leiterbahnabstand und höhere Ausbreitungsgeschwindigkeiten, während sich aufgrund des geringen Schrumpfes gute Planarisierungseigenschaften ergeben. Strukturen mit relativ hohem Aspektverhältnis können mit BCB aber nicht vollständig planarisiert werden, so daß sich bei mehreren Lagen die Unebenheiten verstärken, was wiederum Probleme mit der Tiefenschärfe bei der Abbildung sehr kleiner Leiterbahnstrukturen mit sich bringt. Die bekannten Strukturen weisen deshalb auch ein niedriges Aspektverhältnis auf (Leiterbahnbreite: 22 µm; Leiterbahnhöhe: 2 µm; BCB-Schichtdicke: 5,5 µm). Da das BCB-Polymer Silicium enthält, ist außerdem die Strukturierung relativ schwierig. BCB kann nämlich nur in einem Sauerstoff/Fluor-Plasma geätzt werden, weshalb kein einfacher siliciumhaltiger Resist verwendet werden kann, sondern eine Hilfsätzmaske aus Metall (Kupfer) erforderlich ist. Diese Kupfer-Ätzmaske wird ihrerseits mittels eines Resists und durch Naßätzen strukturiert und nach der BCB-Ätzung in Salpetersäure aufgelöst.

Auch die Leiterbahnen, die aus Aluminium bestehen, werden mittels eines Resists und durch Naßätzen erzeugt, d.h. durch ein Verfahren, das kein hohes Aspektverhältnis erlaubt.

Auch bei einem anderen bekannten Verfahren zum Aufbau von MCMs werden die Leiterbahnen, die aus Kupfer bestehen, mittels eines Resists und durch Naßätzen erzeugt ("SPE Conference on Photopolymer Principles - Processes and Materials", Ellenville N.Y., 28. bis 30. Oktober 1991, Tagungsbericht Seiten 401 bis 416). Trotz des relativ niedrigen Aspektverhältnisses (Leiterbahnbreite: 18 µm; Leiterbahnhöhe: 5 µm) ist hierbei eine spezielle Planarisierungstechnik notwendig, bei der ein photosensitives Polyimid über die erzeugten Leiterbahnen aufgebracht und - in einem zusätzlichen Lithographieschritt - in der Weise belichtet wird, daß es auf den Leiterbahnen durch Entwickeln entfernt werden kann, zwischen den Leiterbahnen aber verbleibt, wodurch die Unebenheiten vermindert werden. Durch eine zweite Lage Polyimid wird dann die restliche Topographie eingeebnet.

Bei einem weiteren bekannten Verfahren kann ebenfalls eine gute Planarisierung erreicht werden ("41th Electronic Components & Technology Conference", 1991, Tagungsbericht Seiten 727 bis 730). Hierbei werden die Leiterbahnstrukturen mittels eines Photoresists und durch Naßätzen einer darunterliegenden Kupferschicht hergestellt. Auf diese Strukturen wird dann bei erhöhter Temperatur eine Kunststoff-Folie aus Polyimid in der Weise laminiert, daß sie die Kupferbahnen einhüllt und auch in die Gräben zwischen den Leiterbahnen gepreßt wird. Dadurch wird zwar eine gute Planarisierung erzielt, jedoch ist dieses Verfahren nur bei Leiterbahngeometrien mit niedrigem Aspektverhältnis anwendbar, welche keine große Angriffsfläche für mechanische Beschädigungen bieten.

Es ist ferner ein Verfahren bekannt, bei dem ein Photoresist auf einer dünnen, auf ein Substrat aufgesputterten Chrom-Kupfer-Schicht photolithographisch strukturiert wird ("34th Electronic Components Conference", 1984, Tagungsbericht Seiten 82 bis 87) und als Seitenbegrenzung für den galvanischen Aufbau der Leiterbahnen dient (Semi-Additivtechnik). Nach dem Strippen des Resists wird die dünne Chrom-Kupfer-Schicht weggeätzt, so daß elektrisch voneinander isolierte Leiterbahnen erhalten werden. Darüber wird dann eine Polyimid-Vorstufe als Dielektrikum aufgebracht, die - nach dem lithographischen Öffnen der Kontaktlöcher - durch Tempern in ein Polyimid überführt wird. Auf diese Weise könnten - mit einem geeigneten Photoresist - prinzipiell zwar Leiterbahnen mit einem hohen Aspektverhältnis hergestellt werden, das Dielektrikum könnte diese Leiterbahnen aber nur sehr ungenügend einebnen, so daß sich dann die Probleme hinsichtlich der Topographie von Ebene zu Ebene verschärfen würden. Die erzeugten Strukturen weisen deshalb lediglich ein Aspektverhältnis von 0,5 auf.

Bei einem anderen nach der Semi-Additivtechnik arbeitenden Verfahren werden die erzeugten Leiterbahnen mit aufgeschleudertem Polyimid abgedeckt ("8th International Electronics Packaging Conference", November 1988, Tagungsbericht Seiten 174 bis 189). Um eine gute Planarisierung zu erreichen, muß aber die dabei erhaltene wellige Schicht durch mechanisches Polieren geglättet werden. Diese Technik ist aber sehr kompliziert, da die Schichtdicke des Dielektrikums über den Leiterbahnen beim Planschleifen schwer zu kontrollieren ist. Wird dabei das Polyimid stellenweise zu sehr abgeschliffen, so kann es an diesen Stellen zum Übersprechen zwischen übereinanderliegenden Leiterbahnen kommen, d.h. zu nicht mehr kontrollierbarer Impedanz, eventuell sogar zu einem Kurzschluß.

Zur Herstellung von MCMs ist ferner ein Verfahren bekannt, bei dem auf einem Wafer mittels eines photosensitiven Polyimids Grabenstrukturen erzeugt und dann auf galvanischem Weg mit Kupfer-Leiterbahnen aufgefüllt werden (EP-PS 0 190 490); dabei kann eine Planarisierung bis zu etwa 90 % erreicht werden. Der Nachteil bei dieser Vorgehensweise besteht in der galvanischen Abscheidung des Kupfers, welche erstens die photolithographische Strukturierung einer dünnen Metallschicht, zweitens die genaue Justierung der Polyimidstrukturen (bezüglich dieser Metallschicht) und drittens die Kontaktierung sämtlicher Leiterbahnen zu einer am Waferrand befindlichen 5 mm breiten Ringelektrode voraussetzt. Die Kontaktierungen müssen später - in einem zusätzlichen Arbeitsschritt (beispielsweise durch Laserablation) - wieder entfernt werden. Im Vergleich zu anderen Techniken benötigt dieses Verfahren einen zusätzlichen Photolithographieschritt zur Strukturierung der Leiterbahnen und ist deshalb wesentlich aufwendiger.

Es ist auch ein Verfahren bekannt, bei dem eine thermisch härtbare, photosensitive Polyimid-Vorstufe eingesetzt wird, über welche eine Metallschicht, im allgemeinen aus Titan, und darüber thermisch nicht härtbares, photosensitives Polyimid aufgebracht wird (EP-OS 0 290 222). Das photosensitive Polyimid wird über eine Maske strukturierend belichtet und dann entwickelt, wodurch die Metallschicht stellenweise freigelegt und an diesen Stellen mit einer Ätzlösung entfernt wird. Dadurch wiederum wird die unterste Lage aus der Polyimid-Vorstufe freigelegt, die dann mit einem geeigneten Lösungsmittel, welches die obere Polyimidschicht nicht angreift, soweit herausgelöst wird, daß die Metallschicht und die Polyimidschicht etwas überhängen. Durch Tempern, beispielsweise bei 320°C, wird die Polyimid-Vorstufe in unlösliches Polyimid überführt; die obere Polyimidschicht bleibt dabei weiterhin löslich. Bei einer erneuten Behandlung mit einer Ätzlösung wird der überhängende Teil der Metallschicht weggeätzt, so daß die untere Polyimidlage nur noch von der oberen Polyimidlage überragt wird. Auf diesen Aufbau wird dann eine dünne Chrom- und danach eine Kupferschicht aufgesputtert und die obere lösliche Polyimidlage (samt den darauf befindlichen Metallschichten) mittels eines Lift-off-Prozesses entfernt. Die verbleibenden relativ dünnen Metallschichten (aus Chrom bzw. Kupfer), die lediglich den Boden und die Seitenwände der Gräben bedecken, dienen als Keimschicht für eine nachfolgende stromlose Abscheidung von Kupfer, durch welche die Gräben vollständig aufgefüllt werden. Auf diese Weise werden Leiterbahnen erzeugt, die mit der Oberkante mit dem Dielektrikum abschließen, d.h. es wird eine plane Ebene gebildet. Darauf wird eine weitere Lage einer thermisch härtbaren, photosensitiven Polyimid-Vorstufe aufgebracht, die strukturierend belichtet und dann entwickelt wird, um Kontaktlöcher freizulegen. Danach beginnt - zum Aufbau der nächsten Ebene - der Prozeß von vorne. Dieses Verfahren, mit dem eine gute Planarisierung des Aufbaus von Ebene zu Ebene erreicht wird, eignet sich dann, wenn relativ breite Leiterbahnen gefordert sind, zur Herstellung von Leiterbahnen mit einem hohen Aspektverhältnis ist es aber nicht geeignet.

Bei einem anderen Verfahren wird eine photosensitive Polyimid-Vorstufe auf ein aufgerauhtes, mit einem Katalysator für stromlose Metallabscheidung vorbehandeltes Substrat aufgebracht (WO 88/05252). Die Polyimid-Vorstufe wird über eine Maske strukturierend belichtet und anschließend entwickelt. Dadurch wird die Katalysatorschicht stellenweise freigelegt, und an diesen Stellen erfolgt dann eine stromlose autokatalytische Metallabscheidung (von Kupfer, Nickel oder Gold). Auch mit diesem Verfahren kann eine gute Planarisierung des Aufbaus von Ebene zu Ebene erreicht werden, wenn relativ breite Leiterbahnen erzeugt werden. Zur Herstellung von Leiterbahnen mit einem hohen Aspektverhältnis ist es jedoch ebenfalls nicht geeignet.

Wenn Leiterbahnen mit einem Aspektverhältnis ≥ 1 aufgebaut werden können (beispielsweise von 1,5), wobei sie hochkant stehend angeordnet sind, so können sie - bei gleichem Querschnitt, d.h. gleichem frequenzabhängigen Widerstand, -dichter gepackt werden, was eine dichtere Packung der Pads auf der Chipseite ermöglichen und die Anzahl der Leiterbahnebenen verringern würde. Dies hätte auch zur Folge, daß die Leiterbahnen - und damit die Laufzeiten der Impulse - verkürzt werden könnten. Wichtig ist dies deshalb, weil mit fortschreitender Verkleinerung der Dimensionen auf den Chips auch die Impulsverzögerungszeiten reduziert werden und somit in die Größenordnung der Laufzeiten gelangen, was zu Störungen der elektrischen Signale führen kann.

Leiterbahnebenen müssen darüber hinaus über definierte Wellenwiderstände verfügen, die sich aus den Ausgangswiderständen der Treiber (Chipausgang) bzw. aus der Geometrie des Multilayersystems der Verbindungstechnik ergeben. Eine Verbindungs- und Aufbautechnik, die es gestattet, Leiterbahnen mit einem Aspektverhältnis > 1 und mit einer Breite herab bis zu ca. 5 bis 10 µm zu erzeugen, würde über entscheidende Vorteile gegenüber den bisher bekannten Techniken verfügen. Ein höheres Aspektverhältnis der Leiterbahnen stellt aber auch höhere Anforderungen an die Planarisierungstechnik, da - bei einer Vielzahl von Ebenen - die Topographie bald höher sein würde als der Spielraum hinsichtlich des Fokus. Eine Verbindungs- und Aufbautechnik der genannten Art muß es deshalb auch ermöglichen, hochkant stehende Leiterbahnen gut zu planarisieren. Ferner muß das zwischen den Leiterbahnen befindliche Dielektrikum eine niedrige Dielektrizitätskonstante besitzen, weil nur dann, wenn die Leiterbahnen dicht gepackt werden können, ohne daß es zu einem Übersprechen kommt, ein hohes Aspektverhältnis von Vorteil ist.

Aufgabe der Erfindung ist es, eine Verbindungs- und Aufbautechnik für Multichip-Module - mit Schichtfolgen aus dielektrischem Material mit darin eingebetteten Leiterbahnen - anzugeben, die auch die Herstellung von Leiterbahnen mit einem Aspektverhältnis ≥ 1 erlaubt.

Dies wird bei einem Verfahren der eingangs genannten Art erfindungsgemäß dadurch erreicht,
- dass als dielektrisches Material ein bis zu mehreren Stunden bei 70°C temperaturstabiles und bei pH 12 basenresistenes Polymer mit einer Dielektrizitätskonstante s 3 verwendet wird, das auf ein nichtleitendes Substrat aufgebracht wird und als Randbegrenzung für einen stromlosen, autokatalytischen Aufbau der Leiterbahnen dient,
- dass das dielektrische Material mit einer Schicht aus in organischen Solventien löslichem Material versehen wird (Lift-off-Schicht),
- dass das dielektrische Material und die Lift-off-Schicht in einem einzigen lithographischen Schritt strukturiert werden, wobei entweder eine direkte oder eine indirekte Strukturierung erfolgt und im dielektrischen Material einen leichten Überhang ihrer Seitenwände aufweisende Gräben mit einem das Verhältnis von Tiefe zu Breite angebenden Aspektverhältnis ≥ 1 gebildet werden,
- dass auf das dielektrische Material bzw. auf die Lift-off-Schicht durch Aufdampfen in gerichteter Weise senkrecht von oben eine metallische Keimschicht aufgebracht wird,
- dass die Lift-off-Schicht mit einem organischen Solvens entfernt wird,
- und dass in den Gräben durch stromlose Metallabscheidung Leiterbahnen erzeugt werden.

Beim erfindungsgemäßen Verfahren werden auf einem geeigneten Substrat, beispielsweise ein Siliciumwafer oder ein Keramiksubstrat mit einer Metällauflage und einem darüber befindlichen Dielektrikum, durch Additivtechnik hochkant stehende Leiterbahnen oder solche mit einem annähernd quadratischen Querschnitt aufgebaut. Die Leiterbahnen werden durch stromlose Metallabscheidung hergestellt, wozu an sich bekannte autokatalytische Bäder dienen, die - mit akzeptablen Abscheideraten - Leiterbahnen mit guter Duktilität des Metalls, beispielsweise Kupfer, liefern. Dabei können gleichzeitig mehrere MCM-Substrate in das Abscheidebad getaucht werden, das umgepumpt und automatisch nachdosiert wird.

Um das stromlose Wachstum der Leiterbahnen - und auch der Kontaktlöcher - in die Breite zu begrenzen, dient als seitliche Begrenzung ein photostrukturiertes Dielektrikum. Dazu werden folgende Maßnahmen ergriffen:
1. Das Dielektrikum wird direkt oder indirekt strukturiert, wobei die Gräben im Dielektrikum die Leiterbahnbreite vorgeben.
2. Über dem Dielektrikum befindet sich eine lösliche, d.h. lift-off-fähige Schicht, welche dieselben Strukturen aufweist wie die dielektrische Schicht. Diese beiden übereinanderliegenden Schichten werden nämlich - in einem einzigen Schritt - gleichzeitig photolithograpisch strukturiert, was in prozeßtechnischer Hinsicht sehr vorteilhaft ist.
3. Nach der Strukturierung der Lift-off-Schicht und des Dielektrikums wird das Substrat (mit den darauf befindlichen Schichten) anisotrop, d.h. in gerichteter Weise, nämlich senkrecht von oben, mit einer dünnen Keimschicht versehen, beispielsweise mit einer durch Bedampfen hergestellten Palladiumschicht.
4. Durch einen Lift-off-Prozeß wird die auf dem Dielektrikum befindliche Schicht - samt der darauf befindlichen Keimschicht - entfernt.

Für den Lift-off-Prozeß ist ein leichter Überhang der Seitenwände der Strukturen vorteilhaft, da auf diese Weise eine Belegung der Seitenwände mit der Keimschicht vermieden werden kann. Damit ist auch gewährleistet, daß sich die Keimschicht für die stromlose Metallabscheidung nur in dem im Dielektrikum freigelegten Boden der Gräben befindet. Andererseits ist sichergestellt, daß ein Aufwachsen der Leiterbahnen von unten her möglich ist, und zwar ohne die Gefahr, daß die Leiterbahnen - im oberen Teil - von der Seite her zuwachsen, wobei darin Hohlräume entstehen würden. Da das Aspektverhältnis der Leiterbahnen ≥ 1 sein soll, ist die Forderung einer ausschließlichen Bekeimung auf dem Boden der Gräben besonders wichtig. Wird nämlich der stromlose Aufbau der Leiterbahnen abgebrochen, wenn die Oberkante des Dielektrikums erreicht ist, dann ist in einfacher Weise eine gute Planarisierung der Leiterbahnebenen möglich.

Zur dielektrischen Isolierung einer Ebene gegenüber der nächsten wird auf die in der vorstehend geschilderten Weise hergestellte Struktur eine weitere Schicht des Dielektrikums aufgebracht, dann werden - in entsprechender Weise - Kontaktlöcher erzeugt. Zum Herstellen der Kontaktlöcher ist aber keine lift-off-fähige Schicht erforderlich, da eine Keimschicht entfallen kann, weil die Kontaktlöcher auf dem darunter befindlichen Kupfer enden. Durch die obere Lage des Dielektrikums werden restliche kleine Unebenheiten der Leiterbahnebene ausgeglichen, so daß nach Abschluß einer kompletten MCM-Ebene wieder von einer glatten Oberfläche ohne Topographie ausgegangen werden kann.

Um eine stromlose Metallabscheidung, insbesondere von Kupfer, zu ermöglichen, muß das Dielektrikum resistent gegen die stark alkalischen Bäder sein (Abscheidebedingungen, je nach Schichtdicke: bis zu mehreren Stunden bei 70°C und pH 12). Das Auslaugen von Beständteilen des Dielektrikums könnte die Stabilität des Bades und die Schichteigenschaften beeinflussen. Das Dielektrikum muß außerdem auch eine gute Haftung zur unteren Ebene aufweisen, damit nicht, wie dies bei einer schlechten Haftung der Fall wäre, Ionen in Spalte zwischen den einzelnen Lagen eindringen und später zur Korrosion im Bauteil führen können. Der thermische Ausdehnungskoeffizient des Dielektrikums sollte möglichst an das Substrat angepaßt sein, um Spannungen, die Abrisse bewirken könnten, zu vermeiden. Die Dehnbarkeit des Dielektrikums sollte dagegen möglichst groß sein, damit unvermeidbare Spannungen bei einem mehrlagigen Aufbau nicht zu Rissen führen.

Das Substrat ist im allgemeinen ein mit Metall und mit einem Dielektrikum beschichteter Siliciumwafer; anstelle des Siliciumwafers kann auch eine plane Platte aus Keramik, Verbundwerkstoff oder Glas verwendet werden. Als Substrat kann außerdem eine mit einem Dielektrikum versehene plane Platte aus Metall dienen. Als dielektrisches Material, das ein temperaturstabiles, basenresistentes Polymer mit einer Dielektrizitätskonstante ≤ 3 ist, dienen insbesondere Polybenzoxazol und Polyimid. Es können aber auch Polyphenylchinoxalin, Polyether und Polybenzocyclobuten sowie andere Polymermaterialien mit entsprechenden Eigenschaften verwendet werden.

Beim Verfahren nach der Erfindung wird das Metall für die Leiterbahnen vorteilhaft aus einer wäßrigen Metallsalzlösung abgeschieden, vorzugsweise aus einer Kupfersalzlösung; als Metall kommen beispielsweise auch Nickel und Gold in Betracht. Die metallische Keimschicht besteht vorteilhaft aus Palladium, das vorzugsweise durch Bedampfen aufgebracht werden kann; außerdem kann die Keimschicht beispielsweise aus Silber sein. Vorteilhaft kann vor der Keimschicht noch eine dünne Haftschicht aufgebracht werden, vorzugsweise aus Chrom; die Haftschicht kann beispielweise aber auch aus Niob bestehen. Die Haftung der Keimschicht - und auch die Haftung der Leiterbahnen - kann noch dadurch verbessert werden, daß das Metall der Keimschicht in einer Clusteranlage aufgedampft wird.

Die gleichzeitige Strukturierung des Dielektrikums und der Lift-off-Schicht erfolgt auf direktem oder indirektem Weg. Für eine direkte Strukturierung ist es erforderlich, daß das dielektrische Material und das Material der Lift-off-Schicht photosensitiv sind. Bei der indirekten Strukturierung wird als Material für die Lift-off-Schicht ein siliciumhaltiger oder silylierbarer Photoresist verwendet und es erfolgt ein Ätzprozeß in einem Sauerstoffplasma. In diesem Fall dient der Resist auch als Ätzstoppschicht für die nächste zu strukturierende Ebene.

Beim Verfahren nach der Erfindung erfolgt die Strukturierung vorzugsweise nach folgenden Techniken, welche die beste Auflösung bei guten Prozeßtoleranzen bieten:
(1) Indirekte Strukturierung mittels eines Positivresist-Prozesses
   Hierbei wird ein Dreilagensystem, bestehend aus einem siliciumhaltigen oder silylierbaren Photoresist, einer lift-off-fähigen Zwischenschicht und einem siliciumfreien organischen Dielektrikum, über eine Maske belichtet, dann wird der Resist entwickelt sowie gegebenenfalls - aus der Gasphase oder aus einer Lösung - silyliert und die Resiststruktur durch reaktives Ionenätzen mittels Sauerstoff (O₂/RIE) in die Zwischenschicht und in das Dielektrikum übertragen. Danach wird eine Keimschicht aufgebracht und der Photoresist sowie die Zwischenschicht mit einem Lösungsmittel, welches das Dielektrikum nicht angreift, entfernt.
(2) Indirekte Strukturierung mittels eines Negativresist-Prozesses
   Hierbei wird ein Zweilagensystem, bestehend aus einem silylierbaren TSI-Resist (TSI = Top Surface Imaging) und einem siliciumfreien organischen Dielektrikum über eine Maske belichtet, dann wird der Resist gegebenenfalls - aus der Gasphase oder aus einer Lösung - silyliert und die Resiststruktur durch Trockenentwickeln der beiden Schichten mittels O₂/RIE in das Dielektrikum übertragen. Danach wird eine Keimschicht aufgebracht und der TSI-Resist mit einem Lösungsmittel, welches das Dielektrikum nicht angreift, entfernt.
(3) Direkte Strukturierung
   Hierbei wird ein Zweilagensystem, bestehend aus einem bei Belichtung ausbleichenden Photoresist (beispielsweise ein Standard-Positivresist) und einem direkt strukturierbaren Dielektrikum (beispielsweise eine Polybenzoxazol-Vorstufe mit Diazonaphthochinon als photoaktive Komponente), über eine Maske belichtet, und dann werden die beiden Schichten entwickelt, beispielsweise mit einem alkalischen Entwickler. Danach wird eine Keimschicht aufgebracht und der Photoresist mit einem Lösungsmittel, welches das Dielektrikum nicht angreift, entfernt. Anschließend wird das Dielektrikum noch getempert.

Die Strukturierung kann aber auch in der Weise erfolgen, daß ein Dreilagensystem, bestehend aus einem Photoresist, einer aufgedampften oder aufgesputterten Metallschicht (beispielsweise aus Aluminium) und einem siliciumfreien organischen Dielektrikum, über eine Maske belichtet, dann der Resist entwickelt und das Metall - naßchemisch oder im Halogenplasma - geätzt wird. Anschließend wird die Struktur im Metall durch O₂/RIE in das Dielektrikum übertragen, wobei der Photoresist völlig verascht. Danach wird die Keimschicht aufgebracht und das Metall - mittels einer geeigneten Säure oder Base - entfernt. Eine weitere Möglichkeit der Strukturierung besteht darin, ein Zweilagensystem, bestehend aus einem Photoresist und einem organischen Dielektrikum, mit einem Excimerlaser über eine Maske zu belichten, so daß die belichteten Stellen beider Schichten ablatiert werden. Danach wird dann die Keimschicht aufgebracht und der Photoresist mit einem Lösungs-mittel entfernt.

Mittels der genannten Strukturierungstechniken können auch Kontaktlöcher problemlos von der obersten bis zur untersten Ebene lagenweise aufgebaut werden, da jede neue Lage auf eine gut planarisierte Unterlage aufgebracht wird und Reflexionen an den unteren Kontaktlöchern keine Rolle spielen. Dies ist bei anderen Techniken nicht immer der Fall. Vielmehr werden dort häufig Kontaktlöcher über mehrere Ebenen wie Treppenstufen angeordnet (sogenannte "stair-stepped via's"), um die Topographie zu mindern und Reflexionen zu vermeiden. Diese Vorgehensweise erfordert aber einen höheren Platzbedarf für die Kontaktlöcher.

Anhand einer Figur soll der Ablauf des Verfahrens nach der Erfindung dargestellt werden. In dieser Figur ist schematisch die Abfolge der einzelnen Prozeßschritte für die Strukturierungstechnik (2) dargestellt. Dabei werden folgende Schritte durchlaufen:
a) auf ein nichtleitendes Substrat wird ein Dielektrikum aufgeschleudert, getrocknet und getempert;
b) auf das Dielektrikum wird ein silylierbarer TSI-Resist aufgebracht und getrocknet;
c) der Resist wird - zum Aufbau von Leiterbahnen - über eine Maske belichtet;
d) der Resist wird silyliert und getrocknet;
e) die Resiststruktur wird in das Dielektrikum übertragen (Trockenentwickeln mittels O₂/RIE);
f) auf die strukturierte Oberfläche wird eine Keimschicht aufgebracht;
g) der Resist wird entfernt (Lift-off-Prozeß);
h) durch stromlose Metallabscheidung werden Leiterbahnen erzeugt;
i) auf die plane Oberfläche wird ein Dielektrikum aufgebracht und getempert;
j) auf das Dielektrikum wird ein silylierbarer TSI-Resist aufgebracht und getrocknet;
k) der Resist wird - zum Aufbau von Durchkontaktierungen - über eine Maske belichtet;
l) der Resist wird silyliert und getrocknet;
m) die Resiststruktur wird in das Dielektrikum übertragen (Trockenentwickeln mittels O₂/RIE) und getempert;
n) durch stromlose Metallabscheidung werden Durchkontaktierungen erzeugt.

Anhand von Ausführungsbeispielen, in denen jeweils der Aufbau eines zweilagigen MCM-Demonstrators mit einem Aspektverhältnis der Leiterbahnen von 1,5 beschrieben wird, soll die Erfindung noch näher erläutert werden.

### Beispiel 1

Auf einen ganzflächig mit einer 5 µm dicken Kupferschicht versehenen 4-Zoll-Siliciumwafer wird eine Polyimid-Vorstufe (als Dielektrikum) aufgeschleudert, bei 100°C getrocknet und unter Stickstoff bei 350°C getempert (Schichtdicke: 9 µm). Dann wird eine 0,2 µm dicke Siliciumdioxidschicht als Ätzstoppschicht aufgesputtert. Der auf diese Weise präparierte Siliciumwafer dient als Substrat. Statt des Siliciumwafers kann auch eine Keramik- oder Glasunterlage als Substrat verwendet werden, der Wafer weist jedoch den Vorteil auf, daß er eine bessere Ebenheit besitzt und von üblichen Prozeßgeräten der Siliciumtechnologie gehaltert und transportiert werden kann.

Auf das Substrat wird eine Polybenzoxazol-Vorstufe (siehe dazu EP-OS 0 291 778 und 0 291 779) aufgeschleudert, bei 100°C getrocknet und unter Stickstoff bei 350°C getempert. Durch das Tempern wird die Vorstufe in basenresistentes Polybenzoxazol (PBO) überführt, das als Dielektrikum dient; dieses Material weist eine Dielektrizitätskonstante von 2,8 auf, die Schichtdicke beträgt 9 µm. Auf das Dielektrikum wird eine Lage eines handelsüblichen Resists auf der Basis von Polyglutarimid in der Weise aufgeschleudert, daß - nach dem Trocknen bei 180°C - eine Schicht mit einer Dicke von 0,5 µm erhalten wird, die eine lift-off-fähige Schicht darstellt. Auf diese Schicht wird eine 0,8 µm dicke Lage eines silylierbaren Resists auf der Basis eines anhydridgruppenhaltigen Polymers aufgeschleudert (siehe dazu: "SPIE Proceedings", Vol. 1262 (1990), Seiten 528 bis 537), dann wird bei 100°C getrocknet, über eine Maske mit 6 µm breiten Leiterbahnstrukturen (die Strukturen sind auf der Maske hell) mit 80 mJ/cm² belichtet (gemessen bei 350 nm auf einem Mask Aligner MA 56, Fa. Süss KG) und in einem wäßrig-alkalischen Entwickler (NMD-W 2,38 %, Fa. Tokyo Ohka) 2 min bei Raumtemperatur entwickelt. Die auf dieser Weise erzeugten Resiststrukturen werden bei Raumtemperatur 3 min in einer wäßrig-alkoholischen Lösung eines oligomeren Diaminosiloxans so silyliert (siehe dazu: "SPIE Proceedings", Vol. 1262 (1990), Seiten 528 bis 537), daß der Schichtzuwachs 0,9 µm beträgt, und dann mittels einer Plasmaätzanlage (MIE 720, Fa. MRC) in 15 min durch die Lift-off-Schicht hindurch in die PBO-Schicht übertragen (O₂-Fluß: 20 sccm; Leistung: 0,8 kW; Druck: 1,5 mTorr); dabei kommt es zu einer Unterätzung von ca. 300 nm. Anschließend wird das Substrat mit der strukturierten PBO-Schicht in einer Bedampfungsanlage (UHV MU 500, Fa. Balzer) mit einer sehr dünnen Haftschicht aus Chrom (ca. 3 nm) und einer 20 nm dicken Palladiumschicht bedampft, und dann werden in einem Ultraschallbad der Resist und die Lift-off-Schicht entfernt. In einem stromlosen Kupferbad (Cu-EDTA-Komplex (EDTA = Ethylendiamintetraessigsäure), Formaldehyd und NaOH; pH 12) werden in den PBO-Gräben bei 70°C innerhalb von 4 h Cu-Leiterbahnen erzeugt, die mit der Oberkante der PBO-Schicht auf 0,5 µm genau abschließen.

Auf die strukturierte Cu/PBO-Schicht wird eine zweite Lage der Polybenzoxazol-Vorstufe aufgeschleudert und in der beschriebenen Weise getrocknet und getempert. Auf die dabei erhaltene zweite PBO-Lage (Schichtdicke: 9 µm) wird - in der beschriebenen Weise - eine 0,8 µm dicke Lage des silylierbaren Resists aufgebracht und getrocknet sowie über eine Maske, welche Kontaktlochstrukturen aufweist, belichtet und dann entwickelt. Die dabei erhaltenen Lochstrukturen werden in der beschriebenen Weise silyliert (Schichtzuwachs: 0,9 µm) und dann in die PBO-Schicht übertragen, wobei der Ätzvorgang an der darunter befindlichen Kupferlage beendet ist. Durch Tempern der nach dem Ätzen verbleibenden Resistschicht bei 350°C wird diese Schicht völlig unlöslich und unterliegt somit keinem Angriff durch eine saure Ätzlösung, mit der die oberflächliche Kupferoxidhaut auf den freigelegten Kontaktlöchern entfernt wird, und durch das Bad, mit dem die Kontaktlöcher stromlos mit Kupfer aufgefüllt werden.

Nach dem Auffüllen der Kontaktlöcher mit Kupfer ist die Herstellung der ersten Ebene abgeschlossen und der Prozeß wiederholt sich mit dem Aufbringen und dem Strukturieren einer PBO-Schicht für die nächste Ebene. Beim Ätzen dieser Schicht im Sauerstoffplasma dient die darunter liegende getemperte Resistschicht als Ätzstoppschicht. An den Stellen, wo Kontaktlöcher von der zweiten Ebene zur ersten Ebene gehen, ist die siliciumhaltige Resistschicht bei der vorangehenden Strukturierung geöffnet, so daß eine metallische Verbindung zwischen den beiden Ebenen gewährleistet ist.

### Beispiel 2

Auf einem Substrat entsprechend Beispiel 1 wird in der dort beschriebenen Weise eine als Dielektrikum dienende PBO-Schicht mit einer Dicke von 9 µm erzeugt. Auf das Dielektrikum wird eine 0,9 µm dicke Lage eines silylierbaren Top-Resists auf der Basis eines anhydridgruppenhaltigen Polymers aufgebracht (siehe dazu: "Microelectronic Engineering", Vol. 20 (1993), Seiten 305 bis 319), dann wird - in entsprechender Weise - getrocknet und über eine Maske, welche Leiterbahnstrukturen aufweist (die Strukturen sind auf der Maske dunkel), mit 200 mJ/cm² belichtet. Nachfolgend wird in der beschriebenen Weise 2 min bei Raumtemperatur silyliert (Schichtzuwachs: 0,9 µm), und dann werden die dabei erhaltenen Leiterbahnstrukturen durch Plasmaätzen (O₂-Fluß: 60 sccm; Leistung: 0,9 kW; Druck: 3 mTorr) in 10 min durch die Resistschicht hindurch in die PBO-Schicht übertragen; dabei erfolgt eine Unterätzung von ca. 300 nm. Anschließend wird - in der beschriebenen Weise - das Substrat mit der strukturierten PBO-Schicht mit einer Haftschicht aus Chrom und einer Palladiumschicht bedampft und der Resist entfernt, und dann werden in den PBO-Gräben - durch stromlose Abscheidung von Kupfer - Cu-Leiterbahnen erzeugt.

Auf der strukturierten Cu/PBO-Schicht wird, wie in Beispiel 1 beschrieben, eine zweite PBO-Lage erzeugt (Schichtdicke: 9 µm). Auf diese PBO-Läge wird eine 1,2 µm dicke Lage des silylierbaren Top-Resists aufgebracht und - in der vorstehend beschriebenen Weise - getrocknet, über eine Maske mit Kontaktlochstrukturen belichtet und silyliert (Schichtzuwachs: 0,9 µm). Die dabei erhaltenen Lochstrukturen werden - in der vorstehend beschriebenen Weise - in die PBO-Schicht übertragen, wobei der Ätzvorgang an der darunter befindlichen Kupferlage beendet ist. Durch Tempern der nach dem Ätzen verbleibenden Schicht des silylierten Top-Resists wird diese Schicht völlig unlöslich. Nach dem Auffüllen der Kontaktlöcher mit Kupfer kann in entsprechender Weise weiter verfahren werden wie in Beispiel 1.

### Beispiel 3

Auf ein Substrat entsprechend Beispiel 1 wird eine Resistlösung - in Form einer Lösung einer Polybenzoxazol-Vorstufe (siehe dazu EP-OS 0 291 778 und 0 291 779) und eines Diesters aus Bisphenol-A und Diazonaphthochinon-5-sulfonsäure (als photoaktive Komponente) in N-Methylpyrrolidon - aufgeschleudert und bei 110°C getrocknet. Auf diesen Resist, der als Vorstufe für das Dielektrikum dient, wird eine Lösung eines weiteren, als Hilfsresist fungierenden Resists - in Form einer Lösung eines handelsüblichen Kresolnovolaks und eines Diesters aus Bisphenol-A und Diazonaphthochinon-5-sulfonsäure (als photoaktive Komponente) in einem Gemisch aus Benzylalkohol und Milchsäureethylester - aufgebracht und bei 100°C getrocknet. Die beiden übereinanderliegenden Resists werden, wie in Beispiel 1 beschrieben, über eine Maske mit 8 µm breiten Leiterbahnstrukturen (die Strukturen sind auf der Maske hell) mit 350 mJ/cm² belichtet und 3 min bei Raumtemperatur entwickelt (Entwickler NMD-W 2,14 %, im Verhältnis 1:1 mit Wasser verdünnt). Dabei wird der untenliegende Resist, der etwas besser basenlöslich ist, stärker entwickelt, so daß es zu einer Unterätzung von ca. 500 nm kommt. Anschließend wird das Substrat mit den strukturierten Resistschichten - in der in Beispiel 1 beschriebenen Weise - mit einer Haftschicht aus Chrom und einer Palladiumschicht bedampft und der obere Resist mit Isopropanol entfernt. Der untere Resist, der eine PBO-Vorstufe darstellt, wird dann bei 350°C unter Stickstoff getempert, wodurch die Vorstufe in basenresistentes Polybenzoxazol überführt wird (Schichtdicke: 9 µm; Dielektrizitätskonstante: 2,9). Nach einer Behandlung des Substrats - für die Dauer von 20 s - im Sauerstoffplasma, wie in Beispiel 1 beschrieben, wird das oberflächlich oxidierte Palladium mit einer wäßrigen Reduktionslösung behandelt und dann werden - in entsprechender Weise wie in Beispiel 1 - in den PBO-Gräben Cu-Leiterbahnen erzeugt, die mit der Oberkante der PBO-Schicht auf 0,5 µm genau abschließen.

Auf die strukturierte Cu/PBO-Schicht wird eine zweite Lage des beschriebenen Resists (aus der PBO-Vorstufe und der photoaktiven Komponente) aufgeschleudert und bei 110°C getrocknet. Dann wird über eine Maske mit Kontaktlochstrukturen - in der vorstehend beschriebenen Weise - mit 300 mJ/cm² belichtet und 2 min bei Raumtemperatur entwickelt. Der Entwicklungsvorgang kommt an der darunter befindlichen Kupferlage zum Stillstand. Anschließend wird der Resist bei 350°C unter Stickstoff getempert, wobei Polybenzoxazol gebildet wird (Schichtdicke: 9 µm). Die oberflächliche Kupferoxidhaut auf den freigelegten Kontaktlöchern wird durch eine saure Ätzlösung entfernt, und dann werden die Kontaktlöcher - in der vorstehend genannten Weise - durch stromlose Metallabscheidung mit Kupfer aufgefüllt.

Nach dem Auffüllen der Kontaktlöcher mit Kupfer ist die Herstellung der ersten Ebene abgeschlossen und der Prozeß wiederholt sich mit dem Aufbringen und dem Strukturieren von Resistschichten für die nächste Ebene. Beim Entwickeln dieser Schichten dient die untenliegende getemperte, alkaliunlösliche PBO-Schicht als Stoppschicht. An den Stellen, wo Kontaktlöcher von der zweiten Ebene zur ersten Ebene gehen, liegt nach der Entwicklung die untere Kupferschicht frei, so daß eine metallische Verbindung zwischen den beiden Ebenen gewährleistet ist.

## Patentansprüche

1. Verfahren zur Herstellung von Multichip-Modulen mit Schichtfolgen aus dielektrischem Material mit darin eingebetteten Leiterbahnen,
wobei
- als dielektrisches Material ein bis zu mehreren Stunden bei 70°C temperaturstabiles und bei pH 12 basenresistentes Polymer mit einer Dielektrizitätskonstante ≤ 3 verwendet wird, das auf ein nichtleitendes Substrat aufgebracht wird und als Randbegrenzung für einen stromlosen, autokatalytischen Aufbau der Leiterbahnen dient,
- das dielektrische Material mit einer Schicht aus in organischen Solventien löslichem Material versehen wird (Lift-off-Schicht).
- das dielektrische Material und die Lift-off-Schicht in einem einzigen lithographischen Schritt strukturiert werden, wobei entweder eine direkte oder eine indirekte Strukturierung erfolgt und im dielektrischen Material einen leichten Überhang ihrer Seitenwände aufweisende Gräben mit einem das Verhältnis von Tiefe zu Breite angebenden Aspektverhältnis ≥ 1 gebildet werden.
- auf das dielektrische Material bzw. auf die Lift-off-Schicht durch Aufdampfen in gerichteter Weise senkrecht von oben eine metallische Keimschicht aufgebracht wird,
- die Lift-off-Schicht mit einem organischen Solvens entfernt wird,
- und in den Gräben durch stromlose Metallabscheidung Leiterbahnen erzeugt werden.

2. Verfahren nach Anspruch 1, **dadurch gekennzeichnet, daß** das dielektrische Material und das Material der Lift-off-Schicht photosensitiv sind und eine direkte Strukturierung erfolgt.

3. Verfahren nach Anspruch 1, **dadurch gekennzeichnet, daß** als Material für die Lift-off-Schicht ein siliciumhaltiger oder silylierbarer Photoresist dient und durch Ätzen im Sauerstoffplasma eine indirekte Strukturierung erfolgt.

4. Verfahren nach einem der Ansprüche 1 bis 3, **dadurch gekennzeichnet, daß** das dielektrische Material Polybenzoxazol oder Polyimid ist.

5. Verfahren nach einem oder mehreren der Ansprüche 1 bis 4, **dadurch gekennzeichnet, daß** die Keimschicht aus Palladium besteht.

6. Verfahren nach einem oder mehreren der Ansprüche 1 bis 5, **dadurch gekennzeichnet, daß** vor der Keimschicht eine dünne Haftschicht, insbesondere aus Chrom, aufgebracht wird.

7. Verfahren nach einem oder mehreren der Ansprüche 1 bis 6, **dadurch gekennzeichnet, daß** das Metall in den Gräben aus einer wäßrigen Metallsalzlösung abgeschieden wird, insbesondere aus einer Kupfersalzlösung.

8. Verfahren nach einem oder mehreren der Ansprüche 1 bis 7, **dadurch gekennzeichnet, daß** als Substrat ein Siliciumwafer verwendet wird, der mit einer dünnen Metallschicht und mit einer dünnen Schicht eines Dielektrikums versehen ist.

9. Verfahren nach einem oder mehreren der Ansprüche 1 bis 8, **dadurch gekennzeichnet, daß** in entsprechender Weise Durchkontaktierungen erzeugt werden.

## Claims

1. Method for producing multichip modules with layer sequences comprising dielectric material with interconnects embedded therein,
- a polymer which is thermostable for up to a number of hours at 70°C, is base-resistant at pH 12 and has a dielectric constant of ≤ 3 being used as dielectric material, which polymer is applied to a nonconductive substrate and serves as edge boundary for an electroless autocatalytic construction of the interconnects,
- the dielectric material being provided with a layer comprising material soluble in organic solvents (lift-off layer),
- the dielectric material and the lift-off layer being patterned in a single lithographic step, either direct or indirect patterning being effected and trenches which have a slight overhang of their sidewalls and have an aspect ratio - specifying the ratio of depth to width - of ≥ 1 being formed in the dielectric material,
- a metallic seed layer being applied to the dielectric material and to the lift-off layer by vapour deposition in a directional manner perpendicularly from above,
- the lift-off layer being removed using an organic solvent,
- and interconnects being produced in the trenches by means of electroless metal deposition.

2. Method according to Claim 1, **characterized in that** the dielectric material and the material of the lift-off layer are photosensitive and direct patterning is effected.

3. Method according to Claim 1, **characterized in that** a silicon-containing or silylatable photoresist serves as material for the lift-off layer and indirect patterning is effected by etching in an oxygen plasma.

4. Method according to one of Claims 1 to 3, **characterized in that** the dielectric material is polybenzoxazole or polyimide.

5. Method according to one or more of Claims 1 to 4, **characterized in that** the seed layer comprises palladium.

6. Method according to one or more of Claims 1 to 5, **characterized in that** a thin adhesion layer, in particular comprising chromium, is applied before the seed layer.

7. Method according to one or more of Claims 1 to 6, **characterized in that** the metal is deposited in the trenches from an aqueous metal salt solution, in particular from a copper salt solution.

8. Method according to one or more of Claims 1 to 7, **characterized in that** a silicon wafer is used as substrate, which silicon wafer is provided with a thin metal layer and with a thin layer of a dielectric.

9. Method according to one or more of Claims 1 to 8, **characterized in that** plated-through holes are produced in a corresponding manner.

## Revendications

1. Procédé de production de modules multi-puces comprenant des successions de couches en matière diélectrique ayant des pistes conductrices qui y sont incorporées, dans lequel
- on utilise comme matière diélectrique un polymère ayant une constante diélectrique ≤ 3, stable à la température à 70°C pendant une à plusieurs heures et résistant aux bases à un pH de 12, qui est déposé sur un substrat non conducteur et qui sert de délimitation de bord pour constituer sans courant et de manière auto-catalytique les pistes conductrices,
- on munit la matière diélectrique d'une couche en une matière soluble dans des solvants organiques (couche de lift-off),
- on structure la matière diélectrique et la couche de lift-off dans un stade lithographique unique en effectuant une structuration directe ou une structuration indirecte et en formant dans la matière diélectrique des sillons ayant un léger surplomb de leur paroi latérale et un rapport d'aspect, indiquant le rapport de la profondeur à la largeur, ≥ 1,
- on dépose sur la matière diélectrique et sur la couche de lift-off de manière dirigée par dépôt en phase vapeur, verticalement à partir du haut, une couche métallique formant germe,
- on élimine la couche de lift-off par un solvant organique,
- et l'on produit des pistes conductrices dans les sillons par dépôt métallique sans courant.

2. Procédé suivant la revendication 1, **caractérisé en ce que** la matière diélectrique et la matière de la couche de lift-off sont photosensibles et on effectue une structuration directe.

3. Procédé suivant la revendication 1, **caractérisé en ce que** l'on se sert comme matière pour la couche de lift-off d'un photo-résist contenant du silicium ou pouvant être silylé et on effectue une structuration indirecte par attaque dans le plasma à l'oxygène.

4. Procédé suivant l'une des revendications 1 à 3, **caractérisé en ce que** la matière diélectrique est un polybenzoxazole ou un polyimide.

5. Procédé suivant l'une ou plusieurs des revendications 1 à 4, **caractérisé en ce que** la couche de germe est en palladium.

6. Procédé suivant l'une ou plusieurs des revendications 1 à 5, **caractérisé en ce qu'**avant la couche de germe on dépose une mince couche d'adhérence, notamment en chrome.

7. Procédé suivant l'une ou plusieurs des revendications 1 à 6, **caractérisé en ce que** l'on dépose le métal dans les sillons à partir d'une solution aqueuse de sel métallique, notamment d'une solution de sel de cuivre.

8. Procédé suivant l'une ou plusieurs des revendications 1 à 7, **caractérisé en ce que** l'on utilise comme substrat une tranche de silicium qui est munie d'une mince couche métallique et d'une mince couche d'un diélectrique.

9. Procédé suivant l'une ou plusieurs des revendications 1 à 8, **caractérisé en ce que** l'on produit des contacts traversant d'une manière adéquate.
